# EUROPÄISCHE PATENTANMELDUNG

(11) **EP 1 257 156 A2**
(43) Veröffentlichungstag der Anmeldung: **13.11.2002**
(21) Anmeldenummer: 02100453.6
(22) Anmeldetag: 07.05.2002
(51) Int. Cl.: H05K 1/16, H01F 27/28

(54) **Flexible Leiterfolie mit einer elektronischen Schaltung**

(30) Priorität: 09.05.2001 DE 10122393
(71) Anmelder: Philips Corporate Intellectual Property GmbH, 20099 Hamburg (DE); Koninklijke Philips Electronics N.V., 5621 BA Eindhoven (NL)
(72) Erfinder: Waffenschmidt, Eberhard, Weisshausstrasse 2, 52066, Aachen (DE); Elixmann, Martin, Weisshausstrasse 2, 52066, Aachen (DE)
(74) Vertreter: Volmer, Georg, Dipl.-Ing.

(57) **Zusammenfassung**

Eine flexible Leiterfolie mit einer elektronischen Schaltung, bestehend aus mindestens einer Lage aus nicht leitendem Material, welche auf wenigsten seiner ihrer Oberflächen ein Leitungsmuster aufweist, ist dadurch gekennzeichnet, dass wenigstens zwei der Leitungsmuster oder Teile wenigstens zweier der Leitungsmuster ein magnetisches Bauteil bilden.

## Beschreibung

Die Erfindung betrifft eine flexible Leiterfolie mit einer elektronischen Schaltung, bestehend aus mindestens einer Lage aus nicht leitendem Material, welche auf wenigstens einer ihrer Oberflächen ein Leitermuster aufweist.

Das Aussehen und das Design von Geräten der Consumer Elektronik spielt eine wesentliche Rolle beim Geschäftserfolg. Um größere gestalterische Freiheit zu gewähren, sind flexible Schaltungen wünschenswert, die zum Beispiel auch wesentlich freier in Gehäusen untergebracht werden können.

Eine Leiterfolie der eingangs genannten Art ist aus der US 5 986 341 bekannt, bei der auf eine biegbare Karte ein Leitungsmuster in Form einer Spule aufgedruckt ist. Diese Spule wird zusammen mit anderen Bauteilen der Dünnschichttechnik, beispielsweise Kondensatoren und integrierten Schaltungen verbunden und in Silikon eingebettet, wobei das Silikon gleichzeitig als Klebmittel für eine Deckfolie dient.

Die WO 99/38 211 beschreibt den Einsatz flexibler Leiterfolien, die auch Halbleiterelemente und Sensoren aufweisen, in der Medizintechnik für die Kopplung zwischen einem elektronischen und einem biologischen System. Weitere biologische Anwendungen werden in dem Einsatz des Mikrosystems als künstliche Netzhaut, als Nervenstimulator oder als Nervenkontakt gesehen.

Aus der EP 0 836 229 A2 ist es bekannt, auf beiden Seiten einer dielektrischen Schicht passive Komponenten aufzubauen und insbesondere einen Kondensator vorzusehen.

Es ist die Aufgabe der Erfindung, eine flexible Leiterfolie zur Verfügung zu stellen, die insbesondere aufgrund der Integration magnetischer Komponenten ein weiteres Anwendungsgsbiet finden kann, wobei die Energiewandlung im Vordergrund stehen soll.

Diese Aufgabe wird durch eine flexible Leiterfolie nach Anspruch 1 gelöst. Vorteilhafte Ausgestaltungen sind Gegenstand der Unteransprüche.

Erfindungsgemäß bilden wenigstens zwei der Leitungsmuster ein magnetisches Bauteil.

Seit mehreren Jahren sind als "Flex-Foils" flexible Folien, beispielsweise auf Polyimidbasis, die Leitungsmuster tragen, verfügbar und werden kommerziell angewendet. Insbesondere in der Leistungselektronik jedoch verhindern voluminöse und starre Bauteile, dass die gesamte Schaltung flexibel wird Hierzu gehören magnetische Bauteile, wie Transformatoren, aber auch Kondensatoren mit höherer Spannungsfestigkeit. Halbleiterbauteile sind hingegen im allgemeinen klein genug, so dass sie, obwohl sie starr sind, trotzdem die Flexibilität der gesamten Schaltung ermöglichen. Es ist bekannt, sie als sogenannte "Naked dies" ohne Gehäuse einzubauen, wie es beispielsweise die WO 99/38211 lehrt. Auch Niederspannungsbauelemente in SMD-Form erfüllen diese Voraussetzungen. Die flexiblen Folien werden vorteilhaft bei der Erfindung eingesetzt.

Nach einer bevorzugten Ausführungsform ist das nicht leitende Material ein dielektrisches Material mit einer Dielektrizitätskonstante εᵣ größer als 4. Dieses wird zum Aufbau eines Kondensators oder mehrerer Kondensatoren verwendet, wobei jeweils eines der Leitungsmuster oder ein Teil des Leitungsmusters eine Kondensatorelektrode bilden kann. Normalerweise hat das für flexible Karten oder Leiterfolien verwendete Material eine Dielektrizitätskonstante, die zwischen 3 und 4 liegt. Erfindungsgemäß werden Materialien mit Dielektrizitätskonstanten im Bereich von 4 bis 100, weiter bevorzugt im Bereich von 10 bis 80 verwendet.

Besonders bevorzugt bildet wenigstens eines der Leitungsmuster eine Spule, so dass aus zwei oder mehr einander gegenüberstehenden derartigen Spulen ein Transformator gebildet werden kann.

Grundsätzlich können somit die magnetischen Bauteile als kernlose, planare Spulen oder Transformatoren ausgeführt werden, welche kein Kernmaterial benötigen. Die Wicklungen sind dann planare Wicklungen aus denselben flexiblen Lagen wie die Leiterbahnen der Schaltung. Kernlose magnetische Bauteile werden insbesondere durch zukünftige höhere Schaltfrequenzen immer besser einsetzbar.

Falls doch Magnetkerne benötigt werden, beispielsweise für Filter oder als Abschirmung, ist es nach einer weiteren bevorzugten Ausführungsform der Erfindung möglich, Lagen zu verwenden, die zumindest einen Abschnitt aus flexiblem magnetischen Material aufweisen. So kann beispielsweise Ferritpulver in einer flexiblen Kunststoffmatrix gebunden sein, wie es aus dem Datenblatt "FPC-Folie C350, C351", Siemens Matsushita Component, Juni 1999, bekannt ist. Dieses Material hat eine niedrige Permeabilitätskonstante, aber auch geringe Wirbelstromverluste, was es für Anwendungen als Trafo- oder Spulenkern oder Abschirmung bei höheren Schaltfrequenzen auszeichnet. Aus dem Katalog der Vakuumschmelze GmbH 1998, "Weichmagnetische Werkstoffe und Halbzeugs", ist ein hochpermeables µ-Metall bekannt, das in dünnen, flexiblen Folien verwendet wird Wegen der hohen Wirbelstromverluste ist dieses Material besonders gut für Filteranwendungen geeignet.

Mit der flexiblen Leiterfolie gemäß der Erfindung ist es möglich, Schaltungen variabel dadurch herzustellen, dass wenigstens zwei der Lagen aus voneinander unterschiedlichem Material bestehen. So lassen sich magnetische Bauteile und elektrische Bauteile vorteilhaft aufbauen. Magnetische Bauteile und Kondensatoren können auch ineinander verschachtelt sein und somit ein LC- oder LCT-Element bilden.

Weitere elektrische und elektronische Bauteile können in der flexiblen Leiterfolie gemäß der Erfindung verwendet werden, beispielsweise Widerstände aus flexiblem Material, flexible Polymerelektronik-Bauteile und Halbleiterbauelemente, für spezielle Anwendungen, beispielsweise in der Medizintechnik, auch Sensoren. Es sollten die notwendigen Halbleiter möglichst klein sein, damit die Schaltung flexibel bleibt. Dazu müssen die Halbleiter in möglichst kleinen Gehäusen, beispielsweise als SMD oder Flip-Chip, vorhanden sein oder vorteilhaft als "naked dies" montiert werden, die dann beispielsweise mittels Bonddrähten kontaktiert werden. Die Halbleiter können in speziellen Gehäusen oder als "naked dies" zwischen zwei Lagen in die Leiterfolie laminiert werden. Polymer-Elektronikbauteile bieten besondere Einsatzmöglichkeiten.

Aus diesem besonderen Kunststofftyp können aktive Bauteile, wie Transistoren und Dioden, aber auch Leuchtdioden und damit Anzeigen hergestellt werden.

Bevorzugt ist die Verwendung einer flexiblen Leiterfolie gemäß der vorliegenden Erfindung bei einer Schaltung zur Leistung-, Energie- oder Spannungswandlung Daneben sind insbesondere Filter, beispielsweise an der Eingangsseite und der Ausgangsseite einer Schaltung mit der Technologie gemäß der Erfindung herstellbar. Dies können Filter zur Reduzierung von Differential-Mode-Störungen und auch Common-Mode-Störungen sein. LC-Filter als T-Filter, pi-Filter und mehrstufige Filter sind möglich, auch in Kombination mit integrierten Dämpfungswiderständen.

Weitere Schaltungen sind ebenfalls denkbar, zum Beispiel eine spezielle Ansteuerelektronik für Displays, für die man eine Gesamtbaudicke des Bildschirms mit Elektronik von 10 mm insbesondere für Plasmapaneldisplays (PDP) erwartet. Die Flexibilität der integrierten Schaltung ist damit hervorragend zur Ansteuerung von Flachbildschirmen geringer Dicke geeignet. Eine besondere Verwendung ergibt sich, wenn man einen flexiblen Bildschirm mit einer flexiblen Leiterfolie gemäß der Erfindung ausstattet.

Eine weitere Anwendungsmöglichkeit besteht darin, ein Kleidungsstück mit einer erfindungsgemäßen flexiblen Leiterfolie zu versehen, wobei hier beispielsweise daran gedacht werden kann, eine Spannungsversorgung für am Körper getragene Abspielgeräte bereitzustellen.

Im folgenden soll die Erfindung anhand der Zeichnung näher erläutert werden. Es zeigt:
Figur 1: einen prinzipiellen Schaltplan eines Halbbrückenkonverters; und
Figur 2 den Lagenaufbau eines solchen Konverters.

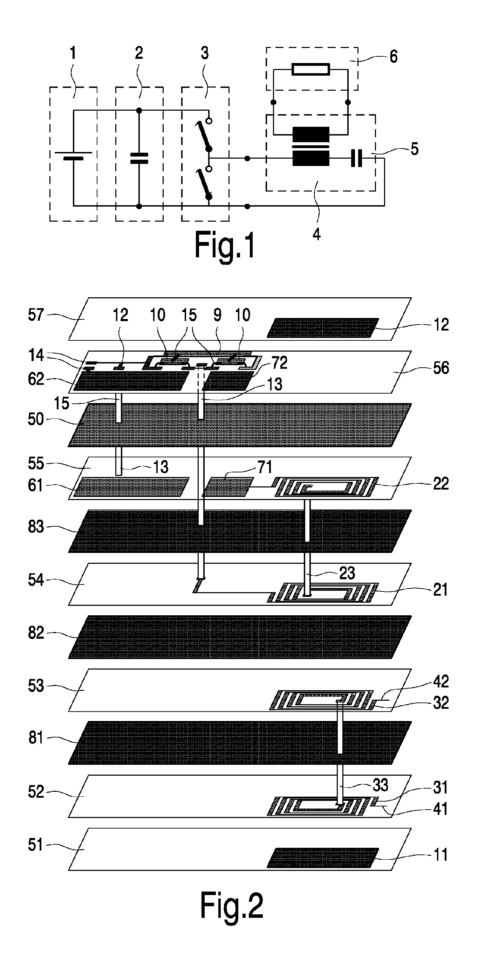

Figur 1 zeigt schematisch einen Halbbrückenkonverter, der als resonanter Konverter ausgelegt werden soll. Parallel zur Spannungsquelle 1 ist ein mittels eines Kondensators aufgebauter Filter 2 gsschaltet, wobei die gefilterte Spannung über die aus zwei Schaltern und gebildete Halbbrücke 3 abgenommen werden kann. Die abgenommene Spannung wird von einem Transformator 4 mit vorgeschaltetem Resonanzkondensator 5 gewandelt und schließlich an eine Last 6 gegeben.

Figur 2 zeigt, wie dieser Konverter aus mehreren flexiblen Lagen unterschiedlichen Materials aufgebaut ist. Eine erste isolierende Schicht 81 liegt zwischen zwei flexiblen Folien 52, 53, die jeweils die Leiterbahnen einer Sekundärwicklung des Transformators als Leitungsmuster 31, 32 enthalten. An jedem Leitungsmuster 31, 32 ist ein Anschluss 41, 42 für die Last auf der Sekundärseite vorgesehen. Unter dem ersten Leitungsmuster 31 auf der Sekundärseite befindet sich auf einer weiteren flexiblen Folie 51 ein flexibler Magnetkern 11. Das erste Leitungsmuster 31 und das zweite Leitungsmuster 32 auf der Sekundärseite sind auf übliche Weise durch eine Durchkontaktierung 33 durch die erste isolierende Schicht 81 verbunden. Auf der flexiblen Folie 53 mit dem zweiten Leitungsmuster 32 auf der Sekundärseite liegt eine zweite isolierende Schicht 82. Die Primärseite des Transformators wird durch einen ähnlichen Aufbau aus einem ersten Leitungsmuster 21 auf einer flexiblen Folie 54, einer darauf angeordneten dritten isolierenden Schicht 83 und einem zweiten Leitungsmuster 22 gebildet, wobei die beiden Leitungsmuster 21, 22 wie zuvor durch eine Durchkontaktierung 23 durch die isolierende Schicht 83 verbunden sind. Die flexible Folie 55, die das zweite Leitungsmuster 22 auf der Primärseite enthält, weist weiterhin eine erste Elektrode 61 für den Filterkondensator und eine erste Elektrode 71 für den Resonanzkondensator auf. Das erste Leitungsmuster 21 der Primärseite ist wiederum mit dem zweiten Leitungsmuster 22 durch eine Durchkontaktierung 23 verbunden. Über dieser flexiblen Folie 55 liegt eine Lage 50 aus dielektrischem Material. Es sind hochkapazitive dielektrische Lagen bekannt, die auf Kunststoffen, beispielsweise Polyimid basieren und mit den üblichen flexiblen Folien kompatibel sind. Über der Lage 50 aus dielektrischem Material ist eine weitere flexible Folie 56 angeordnet, die neben der zweiten Elektrode 62 des Filterkondensators und der zweiten Elektrode 72 des Resonanzkondensators Halbleiterschalter 10 als "naked dies" sowie einen Controller 9 trägt. Diese sind mittels Leiterbahnen auf die gewünschte Weise verschaltet. Zur Kontaktierung der Elektroden 61, 62 des Filterkondensators werden Bonddrähte 15 verwendet, ebenso wie zur Verschaltung der Halbleiterschalter 10. Ferner sind an der flexiblen Folie 56 die Anschlüsse 14 für die Eingangsspannung angebracht. Schließlich liegt über dem zweiten Leitungsmuster 22 ein flexibler Magnetkern 12, der ebenfalls auf einer flexiblen Folie 57 liegt.

Die beschriebene Schaltung kann zur Wandlung von Spannungen verwendet werden, beispielsweise vom Netz mit 230 V auf Spannungen, die im Gerät benötigt werden. Auch Batterieladegeräte verwenden solche Schaltungen. Abwandlungen auf Sperrwandler, Durchflusswandler, Vollbrückenkonverter und dergleichen sind möglich. Insbesondere beim Anschluss an das Netz mit 230 V kann durch entsprechende Auslegung der Schaltung die Schutzisolierung gewährleistet werden. Auch Schaltungen zur Leistungsfaktorkorrektur sind gemäß der Technologie der vorliegenden Erfindung herstellbar. Weiter sind Schaltungen denkbar, die Batteriespannungen zu Spannungen konvertieren, die in einer Schaltung benötigt werden. Hier sind Anwendungen denkbar, bei der die Elektronik in Kleidung integriert ist. Im allgemeinen ist hier keine Potentialtrennung notwendig. Klassische Schaltungen dazu sind Hochsetzsteller, Tiefsetzsteller und deren Abwandlungen Text

## Patentansprüche

1. Flexible Leiterfolie mit einer elektronischen Schaltung, bestehend aus
- mindestens einer Lage (50, 51, 52, 53, 54, 55, 56, 81, 82, 83) aus nicht leitendem Material, welche auf wenigsten einer ihrer Oberflächen ein Leitungsmuster (21, 22, 31, 32, 61, 62, 71, 72) aufweist;
**dadurch gekennzeichnet,**
**dass** wenigstens zwei der Leitungsmuster (21, 22, 31, 32) oder Teile wenigstens zweier der Leitungsmuster mindestens ein magnetisches Bauteil bilden.

2. Flexible Leiterfolie nach Anspruch 1,
**dadurch gekennzeichnet,**
**dass** die Leitungsmuster (21, 22, 31, 32, 61, 62, 71, 72) auf flexiblen Folien (52, 53, 54, 55, 56) angeordnet sind

3. Flexible Leiterfolie nach Anspruch 1,
**dadurch gekennzeichnet,**
**dass** das nicht leitende Material ein dielektrisches Material mit Dielektrizitätskonstante εᵣ größer als 4 ist.

4. Flexible Leiterfolie nach Anspruch 1,
**dadurch gekennzeichnet,**
**dass** wenigstens eines der Leitungsmuster eine Kondensatorelektrode (61, 62, 71, 72) bildet.

5. Flexible Leiterfolie nach Anspruch 1,
**dadurch gekennzeichnet,**
**dass** wenigstens eines der Leitungsmuster (21, 22, 31, 32) eine Spule oder einen Transformator bildet.

6. Flexible Leiterfolie nach Anspruch 1,
**dadurch gekennzeichnet,**
**dass** mindestens eine der Lagen (51, 56) einen Abschnitt aus flexiblem magnetischem Material (11, 12) aufweist.

7. Flexible Leiterfolie nach einem der Ansprüche 1 bis 6,
**dadurch gekennzeichnet,**
**dass** wenigstens zwei der Lagen aus voneinander unterschiedlichem Material bestehen.

8. Flexible Leiterfolie nach einem der Ansprüche 1 bis 7,
**dadurch gekennzeichnet,**
**dass** sie mindestens einen Widerstand aus flexiblem Material aufweist.

9. Flexible Leiterfolie nach einem der Ansprüche 1 bis 8,
**dadurch gekennzeichnet,**
**dass** sie flexible Polymerelektronik-Bauteile aufweist.

10. Flexible Leiterfolie nach einem der Ansprüche 1 bis 9,
**dadurch gekennzeichnet,**
**dass** mindestens ein Halbleiterbauelement (9, 10) einlaminiert ist.

11. Flexible Leiterfolie nach einem der Ansprüche 1 bis 10,
**dadurch gekennzeichnet,**
**dass** mindestens ein Sensor zum Umwandeln einer physikalischen Messgröße in ein elektronisches Signal.

12. Verwendung einer flexiblen Leiterfolie nach einem der Ansprüche 1 bis 11 bei einer Schaltung zur Leistungs-, Energie- oder Spannungswandlung.

13. Kleidungsstück, mit einer flexiblen Leiterfolie nach einem der Ansprüche 1 bis 11.

14. Flexibler Bildschirm, mit einer flexiblen Leiterfolie nach einem der Ansprüche 1 bis 11.
